# EUROPEAN PATENT SPECIFICATION

(11) **EP 3 193 424 B1**
(45) Date of publication and mention of the grant of the patent: **25.01.2023**
(21) Application number: 14884733.8
(22) Date of filing: 08.12.2014
(51) Int. Cl.: H02J 7/00, G01R 19/165

(54) **BATTERY IN-POSITION DETECTION APPARATUS, METHOD, AND CHARGING SYSTEM**
GERÄT, VERFAHREN UND LADESYSTEM ZUR ERKENNUNG DER LAGE DER BATTERIE
APPAREIL, PROCÉDÉ ET SYSTÈME DE CHARGE POUR LA DÉTECTION DE LA POSITION DE LA BATTERIE

(30) Priority: 11.10.2014 CN 201410535834
(43) Date of publication of application: 19.07.2017
(73) Proprietor: ZTE Corporation, Shenzhen, Guangdong 518057 (CN)
(72) Inventor: HE, Wei, Shenzhen Guangdong 518057 (CN)
(74) Representative: Wallinger Ricker Schlotter Tostmann
(86) International application number: PCT/CN2014/093280
(87) International publication number: WO 2015/131596

(56) References cited:
- EP-A2- 0 607 041
- CN-A- 1 766 656
- CN-A- 101 086 516
- CN-A- 103 353 566
- CN-A- 103 545 882
- JP-A- 2001 057 247
- US-A- 5 859 481
- US-A1- 2005 116 687
- US-B1- 6 181 103
- US-B1- 6 340 876

## Description

### Technical Field

The present invention relates to the technical field of management of battery charging and discharging, and in particularly, to a battery in-position detection apparatus and method and a charging system.

### Background

Communication devices are usually equipped with charging batteries, charging and discharging of which need to be managed. In particularly, for a large-scale communication device put on unattended places such as a telecommunications room, an outdoor cabinet, a tower top, etc., to guarantee reliability of the communication device, it is generally required that the communication device can operate for a period of time even in a power failure state. Battery connection failure due to battery failure or human errors will have potential effect on normal operation of the communication device if in-position situation of battery cannot be detected in time. Therefore, battery management function of the communication device will typically include battery in-position detection function. If the battery is in-position state normally, the battery of the communication device can be charged and discharged normally. Once battery failure or battery connection failure occurs, an alarm can be sent out through battery in-position detection to facilitate maintenance and processing, thereby ensuring normal operation of the battery.

The existing art detects whether a battery is in-position by detecting voltages across battery ports after on and off of a switch of the battery. Using such detection method in which only voltage is detected has the following problems: 1) A method for detecting the battery voltage by turning off the switch requires to turn on and off the switch of the battery. If the switch is off, isolated sampling is generally required, which makes the circuit too complicated. If there is no isolation, a charging voltage cannot be distinguished from a battery voltage. Therefore, the detection method in which only voltage is detected cannot determine reliably whether the battery is in-position; 2) Frequent on and off of the switch of the battery influences the life of the switch. 3) Since an accumulator battery is a comparatively large capacitive load, frequent on and off of the switch will generate big impulse voltages and current spikes, which brings damage to power supply of the device and causes damage of protection of the device.

The JP 2001 057247 A discloses a chargeable battery and a chargeable battery pack having an internal circuit. The US 6 340 876 B1 discloses a system and method for detecting battery removal or absent battery condition in a charger without use of external stimulus such as a thermistor, EEPROM, or additional pin. The US 6 181 103 B1 discloses an advanced intelligent computer power management (AICPM) system. The US 5 859 481 A discloses an apparatus for sensing the presence of an auxiliary battery connected to a cellular telephone. The EP 0 607 041 A2 discloses a portable computer main body includes a power source circuit section having a battery pack. The US 2005/0116687 A1 discloses a charging device that makes it possible to prevent a current control element supplying current from an AC adapter from being turned OFF and to prevent the light emission of a light-emitting element indicating that charging is in progress from being terminated even when there is a reflux current from the secondary cell. The CN 103 545882 A discloses a battery presence detecting apparatus.

### Summary

Embodiments of the present invention provide a battery in-position detection apparatus and method and a charging system to solve a problem of switch life caused by ignition of a switch of a battery and a problem of influence of impulse voltages and currents on power supply of a device during a process of detecting battery in-position using a voltage detection method in the above-described existing art, and solve problems of unreliability and high complexity of a circuit in the voltage detection method.

The above problem is solved by a method according to claim 1 and an apparatus according to claim 2. Further improvements and embodiments are provided in the dependent claims.

A technical scheme used by embodiments of the present invention is as follows.

A battery in-position detection method includes:
detecting a current of a charging circuit;
comparing a direction of the current with a preset direction and comparing a value of the current with a determination threshold; and
determining whether the battery is in-position according to comparison results,
where the preset direction is a charging current direction, and the determination threshold is a minimum floating charging current at a maximum floating charging voltage, characterized in that, said determining whether the battery is in-position according to comparison results comprises:
   determining that the battery is discharging and the battery is in-position when the direction of the current is opposite to the preset direction;
   determining that the battery is not in-position when the value of the current is zero; and
   determining that the battery is in-position when the direction of the current is the same as the preset direction and the value of the current is greater than or equal to the determination threshold,
   wherein the in-position refers to the battery is properly connected.

The method further includes:
adjusting a charging voltage when the direction of the current is the same as the preset direction and the value of the current is less than the determination threshold.

Adjusting the charging voltage includes:
adjusting the charging voltage from a floating charging voltage to an equalizing charging voltage.

The method further includes:
after the charging voltage is adjusted from the floating charging voltage to the equalizing charging voltage, detecting a current of the charging circuit at the equalizing charging voltage; determining that the battery is in-position when the value of the current of the charging circuit is greater than or equal to the determination threshold; and determining that the battery is not in-position when the value of the current of the charging circuit is less than the determination threshold.

An embodiment of the present invention further provides a battery in-position detection apparatus including a current detection module, a comparison module and a logic control module.

The current detection module, connected in series in a charging circuit, is arranged to detect a current of the charging circuit.

The comparison module is arranged to compare a direction of the current with a preset direction, compare a value of the current with a determination threshold, and obtain comparison results.

The logic control module is arranged to determine whether the battery is in-position through the comparison results,
where the preset direction is a charging current direction, and the determination threshold is a minimum floating charging current at a maximum floating charging voltage, characterized in that, the logic control module being arranged to determine whether the battery is in-position through the comparison results means that:
the logic control module is arranged to,
determine that the battery is discharging and the battery is in-position when the direction of the current is opposite to the preset direction;
determine that the battery is not in-position when the value of the current is zero; and
determine that the battery is in-position when the direction of the current is the same as the preset direction and the value of the current is greater than or equal to the determination threshold,
wherein the in-position refers to the battery is properly connected.

The apparatus further includes a charging voltage adjusting module, herein:
the logic control module is further arranged to trigger the charging voltage adjusting module when the direction of the current is the same as the preset direction and the value of the current is less than the determination threshold; and
the charging voltage adjusting module is arranged to adjust the charging voltage from a floating charging voltage to an equalizing charging voltage.

The current detection module is further arranged to detect a current of the charging circuit at the equalizing charging voltage; and
the logic control module is further arranged to determine that the battery is in-position when the value of the current of the charging circuit is greater than or equal to the determination threshold; and determine that the battery is not in-position when the value of the current of the charging circuit is less than the determination threshold.

In an exemplary embodiment, the current detection module includes a resistance or Hall element.

An embodiment of the present invention further provides a charging system including a charger, a battery, and the battery in-position detection apparatus described above.

The charger is arranged to charge the battery through the charging circuit.

The current detection module of the battery in-position detection apparatus is connected in series in the charging circuit.

Compared with the existing art, the embodiments of the present invention have the following beneficial effects:
Through the method in which the current of the charging circuit is detected, and the detected current signal is compared with the preset current signal, and whether the battery is in-position is determined according to the comparison results, the embodiments of the present invention can improve accuracy of the detection and reliability of the circuit.

### Brief Description of the Drawings

FIG. 1 is a flow chart of a battery in-position detection method in accordance with an embodiment of the present invention.
FIG. 2 is a block diagram of a battery in-position detection apparatus in accordance with an embodiment of the present invention.
FIG. 3 is a block diagram of a charging system in accordance with an embodiment of the present invention.
FIG. 4 is a block diagram of a charging system in accordance with an embodiment of the present invention combined with an existing manner for determining a voltage of a battery circuit.

### Detailed Description

To make object, technical scheme and beneficial effects of the present invention clearer and plainer, embodiments of the present invention will be described below in conjunction with the accompanying drawings. It should be noted that the embodiments of the present application and features in the embodiments can be combined with each other arbitrarily without conflict.

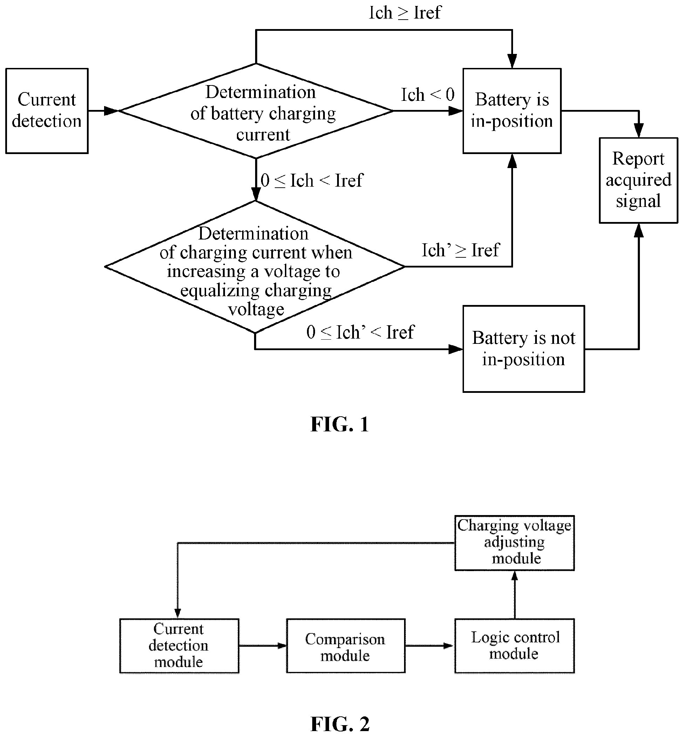

As shown in FIG. 1, a battery in-position detection method includes:
detecting a current of a charging circuit, herein, the current is represented by Ich (if there is a battery switch in the charging circuit, the switch needs to be turned on);
comparing a direction and magnitude of the current Ich with a preset direction and a determination threshold Iref respectively; and
determining whether the battery is in-position according to comparison results.

Through the method in which the current of the charging circuit is detected, and the detected current signal is compared with the preset current signal, and whether the accumulator battery is in-position is determined according to the comparison results, the design can be simplified and accuracy of the detection and reliability of the circuit can be improved. Detecting the current Ich in the charging circuit may be performed in a sampling manner. The embodiments of the present invention are not limited thereto.

When the magnitude of the current Ich is compared with that of the determination threshold Iref, the magnitudes of the current Ich and the determination threshold Iref may be amplified in the same proportion and then compared to determine whether the accumulator battery is in-position.

The preset direction is a charging current direction. The determination threshold Iref > 0, and may be configured according to different types of batteries. The determination threshold Iref in the embodiment of the present invention is configured to be the minimum floating charging current at the maximum floating charging voltage.

Determining whether the battery is in-position according to the comparison results includes:
determining that the battery discharges and the battery is in-position when the direction of the current Ich is opposite to the preset direction (or the value of the current Ich is negative);
determining that the battery is not in-position when the value of the current Ich is zero (i.e., no current signal);
determining that the battery is in-position when the direction of the current Ich is the same as the preset direction and the value of the current Ich is greater than or equal to the determination threshold Iref; and
adjusting a charging voltage when the direction of the current Ich is the same as the preset direction and the value of the current Ich is less than the determination threshold Iref.

Adjusting the charging voltage includes: adjusting the charging voltage from a floating charging voltage to an equalizing charging voltage.

After the charging voltage is adjusted from the floating charging voltage to the equalizing charging voltage, the method further includes:
detecting a current Ich' of the charging circuit at the equalizing charging voltage;
determining that the battery is in-position when the value of the current Ich' is greater than or equal to the determination threshold Iref; and
determining that the battery is not in-position when the value of the current Ich' is less than the determination threshold Iref.

As shown in FIG. 2, an embodiment of the present invention further provides a battery in-position detection apparatus including a current detection module, a comparison module and a logic control module.

The current detection module, connected in series in a charging circuit, is arranged to detect a current Ich of the charging circuit.

The comparison module is arranged to compare a direction and magnitude of the current Ich with a preset direction Iref and a determination threshold Iref respectively, and obtain comparison results.

The logic control module is arranged to determine whether the battery is in-position through the comparison results.

Herein, the preset direction is a charging current direction, and the determination threshold Iref is the minimum floating charging current at the maximum floating charging voltage. The operation that the logic control module determines whether the battery is in-position through the comparison results means that:
the logic control module determines that the battery is discharging and the battery is in-position when the direction of the current Ich is opposite to the preset direction;
the logic control module determines that the battery is not in-position when the value of the current Ich is zero;
the logic control module determines that the battery is in-position when the direction of the current Ich is the same as the preset direction and the value of the current Ich is greater than or equal to the determination threshold Iref; and
the logic control module triggers a charging voltage adjusting module when the direction of the current Ich is the same as the preset direction and the value of the current Ich is less than the determination threshold Iref.

The charging voltage adjusting module is arranged to adjust the charging voltage from a floating charging voltage to an equalizing charging voltage.

The current detection module is further arranged to detect a current Ich' of the charging circuit at the equalizing charging voltage.

The logic control module is further arranged to determine that the battery is in-position when the value of the current Ich' is greater than or equal to the determination threshold Iref; and determine that the battery is not in-position when the value of the current Ich' is less than the determination threshold Iref.

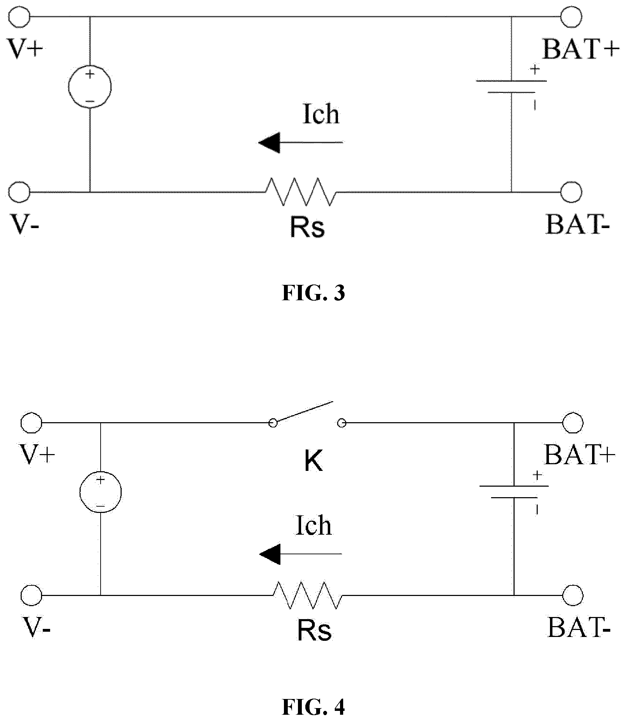

A charging system provided by an embodiment of the present invention, as shown in FIG. 3, includes the battery in-position detection apparatus described above, a charger (with a charging voltage V), a battery (with a battery supply voltage BAT). Herein, the charger and battery in the embodiment of the present invention may use the existing modules in the related communication device.

The charger is arranged to charge the battery through the charging circuit.

The current detection module of the battery in-position detection apparatus is connected in series in the charging circuit. The current detection module includes a resistance Rs or Hall element.

The battery in-position detection method in embodiments of the present invention may be combined with a manner for determining whether the voltage of the battery circuit is within the specified scope of the voltage. As shown in FIG. 4, a switch K is added in the charging circuit. Through on and off of the switch K, it is determined whether the battery is in-position by detecting the voltage across the battery ports, such that it can be determined more deeply whether the battery is in-position or the battery is damaged.

### Industrial Applicability

Through the method in which the current of the charging circuit is detected, and the detected current signal is compared with the preset current signal, and whether the battery is in-position is determined according to the comparison results, accuracy of the detection and reliability of the circuit can be improved.

## Claims

1. A battery in-position detection method, comprising:
detecting a current of a charging circuit;
comparing a direction of the current with a preset direction, and comparing a value of the current with a determination threshold; and
determining whether a battery is in-position according to comparison results,
wherein the preset direction is a charging current direction, and the determination threshold is a minimum floating charging current at a maximum floating charging voltage, **characterized in that**, said determining whether the battery is in-position according to comparison results comprises:
determining that the battery is discharging and the battery is in-position when the direction of the current is opposite to the preset direction;
determining that the battery is not in-position when the value of the current is zero; and
determining that the battery is in-position when the direction of the current is the same as the preset direction and the value of the current is greater than or equal to the determination threshold,
wherein the in-position refers to the battery is properly connected, and
wherein the method further comprises:
adjusting a charging voltage when the direction of the current is the same as the preset direction and the value of the current is less than the determination threshold; wherein,
said adjusting the charging voltage comprises:
adjusting the charging voltage from a floating charging voltage to an equalizing charging voltage, and the method further comprising:
after the charging voltage is adjusted from the floating charging voltage to the equalizing charging voltage,
detecting a current of the charging circuit at the equalizing charging voltage;
determining that the battery is in-position when the value of the current of the charging circuit is greater than or equal to the determination threshold; and
determining that the battery is not in-position when the value of the current of the charging circuit is less than the determination threshold.

2. A battery in-position detection apparatus including a current detection module, a comparison module and a logic control module; wherein
the current detection module, connected in series in a charging circuit, is arranged to detect a current of the charging circuit;
the comparison module is arranged to compare a direction of the current with a preset direction, compare a value of the current with a determination threshold, and obtain comparison results; and
the logic control module is arranged to determine whether a battery is in-position through the comparison results,
wherein the preset direction is a charging current direction, and the determination threshold is a minimum floating charging current at a maximum floating charging voltage, **characterized in that**, the logic control module being arranged to determine whether the battery is in-position through the comparison results means that:
the logic control module is arranged to,
determine that the battery is discharging and the battery is in-position when the direction of the current is opposite to the preset direction;
determine that the battery is not in-position when the value of the current is zero; and
determine that the battery is in-position when the direction of the current is the same as the preset direction and the value of the current is greater than or equal to the determination threshold,
wherein the in-position refers to the battery is properly connected, and
wherein the apparatus further comprises a charging voltage adjusting module, wherein,
the logic control module is further arranged to trigger the charging voltage adjusting module when the direction of the current is the same as the preset direction and the value of the current is less than the determination threshold; and
the charging voltage adjusting module is arranged to adjust a charging voltage from a floating charging voltage to an equalizing charging voltage,
wherein the current detection module is further arranged to detect a current of the charging circuit at the equalizing charging voltage; and
the logic control module is further arranged to determine that the battery is in-position when the value of the current of the charging circuit is greater than or equal to the determination threshold; and determine that the battery is not in-position when the value of the current of the charging circuit is less than the determination threshold.

3. The apparatus according to claim 2, wherein the current detection module includes a resistance or Hall element.

4. A charging system comprising a charger, a battery, and the battery in-position detection apparatus according to any one of claims 2 to 3, wherein
the charger is arranged to charge the battery through the charging circuit; and
the current detection module of the battery in-position detection apparatus is connected in series in the charging circuit.

## Patentansprüche

1. Verfahren zur Erkennung einer In-Position einer Batterie, welches umfasst:
ein Erfassen eines Stroms einer Ladeschaltung,
ein Vergleichen einer Richtung des Stroms mit einer voreingestellten Richtung, und ein Vergleichen eines Wertes des Stroms mit einem Bestimmungsschwellenwert, und
ein Bestimmen, ob gemäß den Vergleichsergebnissen eine Batterie in In-Position ist,
wobei die voreingestellte Richtung eine Ladestromrichtung ist und der Bestimmungsschwellenwert ein minimaler erdfreier Ladestrom bei einer maximalen erdfreien Ladespannung ist, **dadurch gekennzeichnet, dass** das Bestimmen, ob die Batterie gemäß den Vergleichsergebnissen in In-Position ist umfasst:
ein Bestimmen, dass die Batterie entladen wird und die Batterie In-Position ist, wenn die Richtung des Stroms entgegengesetzt zu der voreingestellten Richtung ist,
ein Feststellen, dass die Batterie nicht in In-Position ist, wenn der Wert des Stroms Null ist, und
ein Bestimmen, dass die Batterie in In-Position ist, wenn die Richtung des Stroms die gleiche wie die voreingestellte Richtung ist und der Wert des Stroms größer oder gleich dem Bestimmungsschwellenwert ist,
wobei sich die In-Position darauf bezieht, dass die Batterie richtig angeschlossen ist, und
wobei das Verfahren ferner umfasst:
ein Einstellen einer Ladespannung, wenn die Richtung des Stroms die gleiche wie die voreingestellte Richtung ist und der Wert des Stroms kleiner als der Bestimmungsschwellenwert ist,
wobei das Einstellen der Ladespannung umfasst:
ein Einstellen der Ladespannung von einer erdfreien Ladespannung auf eine Ausgleichsladespannung, und wobei das Verfahren ferner umfasst:
nachdem die Ladespannung von der erdfreien Ladespannung auf die Ausgleichsladespannung eingestellt ist,
ein Erfassen eines Stroms der Ladeschaltung bei der Ausgleichsladespannung,
ein Bestimmen, dass die Batterie in In-Position ist, wenn der Wert des Stroms der Ladeschaltung größer als oder gleich dem Bestimmungsschwellenwert ist, und
ein Bestimmen, dass die Batterie nicht in In-Position ist, wenn der Wert des Stroms der Ladeschaltung kleiner als der Bestimmungsschwellenwert ist.

2. Vorrichtung zur Erkennung der Batterieposition, die ein Stromerfassungsmodul, ein Vergleichsmodul und ein Modul einer Logiksteuerung aufweist, wobei
das Stromerfassungsmodul, das in Reihe in einem Ladestromkreis geschaltet ist, eingerichtet ist, um einen Strom des Ladestromkreises zu erfassen,
das Vergleichsmodul eingerichtet ist, um eine Richtung des Stroms mit einer voreingestellten Richtung zu vergleichen, um einen Wert des Stroms mit einer Bestimmungsschwelle zu vergleichen und um Vergleichsergebnisse zu erhalten, und
das Modul der Logiksteuerung eingerichtet ist, um anhand der Vergleichsergebnisse zu bestimmen, ob eine Batterie in In-Position ist,
wobei die voreingestellte Richtung eine Ladestromrichtung ist, und der Bestimmungsschwellenwert ein minimaler erdfreier Ladestrom bei einer maximalen erdfreien Ladespannung ist, **dadurch gekennzeichnet, dass** das Modul der Logiksteuerung so eingerichtet ist, dass es anhand der Vergleichsergebnisse bestimmt, ob die Batterie In-Position ist, was bedeutet, dass
das Modul der Logiksteuerung eingerichtet ist,
um festzustellen, dass die Batterie entladen wird und die Batterie in In-Position ist, wenn die Richtung des Stroms entgegengesetzt zu der voreingestellten Richtung ist,
um festzustellen, dass die Batterie nicht in In-Position ist, wenn der Wert des Stroms Null ist, und
um festzustellen, dass die Batterie in In-Position ist, wenn die Richtung des Stroms die gleiche wie die voreingestellte Richtung ist und der Wert des Stroms größer oder gleich dem Bestimmungsschwellenwert ist,
wobei sich die In-Position darauf bezieht, dass die Batterie richtig angeschlossen ist, und
wobei die Vorrichtung ferner ein Modul zur Einstellung der Ladespannung aufweist, wobei,
das Modul der Logiksteuerung ferner so eingerichtet ist, dass es das Modul zur Einstellung der Ladespannung auslöst, wenn die Richtung des Stroms die gleiche wie die voreingestellte Richtung ist und der Wert des Stroms kleiner als der Bestimmungsschwellenwert ist, und
das Modul zur Einstellung der Ladespannung eingerichtet ist, um eine Ladespannung von einer erdfreien Ladespannung auf eine Ausgleichsladespannung einzustellen,
wobei das Stromerfassungsmodul ferner eingerichtet ist, um einen Strom der Ladeschaltung bei der Ausgleichsladespannung zu erkennen, und
das Modul der Logiksteuerung ferner eingerichtet ist, um zu bestimmen, dass die Batterie in In-Position ist, wenn der Wert des Stroms der Ladeschaltung größer als oder gleich dem Bestimmungsschwellenwert ist, und um zu bestimmen, dass die Batterie nicht in In-Position ist, wenn der Wert des Stroms der Ladeschaltung kleiner als der Bestimmungsschwellenwert ist.

3. Vorrichtung nach Anspruch 2, wobei das Stromerfassungsmodul ein Widerstands- oder Hall-Element enthält.

4. Ladesystem, das ein Ladegerät, eine Batterie und die Vorrichtung zur Erkennung der Batterieposition nach einem der Ansprüche 2 bis 3 aufweist, wobei
das Ladegerät eingerichtet ist, um die Batterie über die Ladeschaltung aufzuladen, und
das Stromerfassungsmodul der Vorrichtung zur Erkennung der Batterieposition in Reihe in den Ladestromkreis geschaltet ist.

## Revendications

1. Procédé de détection de position de fonctionnement d'une batterie, comprenant :
détecter un courant d'un circuit de charge ;
comparer une direction du courant avec une direction prédéfinie, et comparer une valeur du courant avec un seuil de détermination ; et
déterminer si une batterie est en position de fonctionnement en fonction des résultats de comparaison,
dans lequel la direction prédéfinie est une direction de courant de charge, et le seuil de détermination est un courant de charge flottante minimal à une tension de charge flottante maximale, **caractérisé en ce que**, l'étape consistant à déterminer si la batterie est en position de fonctionnement en fonction des résultats de comparaison comprend :
déterminer que la batterie se décharge et que la batterie est en position de fonctionnement quand la direction du courant est opposée à la direction prédéfinie ;
déterminer que la batterie n'est pas en position de fonctionnement quand la valeur du courant est nulle ; et
déterminer que la batterie est en position de fonctionnement quand la direction du courant est la même que la direction prédéfinie et que la valeur du courant est supérieure ou égale au seuil de détermination,
dans lequel la position de fonctionnement se réfère au fait que la batterie est correctement connectée, et
dans lequel le procédé comprend en outre :
régler une tension de charge quand la direction du courant est la même que la direction prédéfinie et que la valeur du courant est inférieure au seuil de détermination ; dans lequel
ladite étape consistant à régler la tension de charge comprend :
régler la tension de charge d'une tension de charge flottante à une tension de charge d'égalisation, et le procédé comprenant en outre :
après l'étape consistant à régler la tension de charge de la tension de charge flottante à la tension de charge d'égalisation,
détecter un courant du circuit de charge à la tension de charge d'égalisation ;
déterminer que la batterie est en position de fonctionnement quand la valeur du courant du circuit de charge est supérieure ou égale au seuil de détermination ; et
déterminer que la batterie n'est pas en position de fonctionnement quand la valeur du courant du circuit de charge est inférieure au seuil de détermination.

2. Appareil de détection de position de fonctionnement d'une batterie incluant un module de détection de courant, un module de comparaison et un module de commande logique ; dans lequel
le module de détection de courant, connecté en série dans un circuit de charge, est adapté pour détecter un courant du circuit de charge ;
le module de comparaison est adapté pour comparer une direction du courant avec une direction prédéfinie, comparer une valeur du courant avec un seuil de détermination, et obtenir des résultats de comparaison ; et
le module de commande logique est adapté pour déterminer si une batterie est en position de fonctionnement par l'intermédiaire des résultats de comparaison,
dans lequel la direction prédéfinie est une direction de courant de charge, et le seuil de détermination est un courant de charge flottante minimal à une tension de charge flottante maximale, **caractérisé en ce que**, la conception du module de commande logique pour déterminer si la batterie est en position de fonctionnement par l'intermédiaire des résultats de comparaison signifie que :
le module de commande logique est adapté pour,
déterminer que la batterie se décharge et que la batterie est en position de fonctionnement quand la direction du courant est opposée à la direction prédéfinie ;
déterminer que la batterie n'est pas en position de fonctionnement quand la valeur du courant est nulle ; et
déterminer que la batterie est en position de fonctionnement quand la direction du courant est la même que la direction prédéfinie et que la valeur du courant est supérieure ou égale au seuil de détermination,
dans lequel la position de fonctionnement se réfère au fait que la batterie est correctement connectée, et
dans lequel l'appareil comprend en outre un module de réglage de tension de charge, dans lequel
le module de commande logique est en outre adapté pour déclencher le module de réglage de tension de charge lorsque la direction du courant est la même que la direction prédéfinie et que la valeur du courant est inférieure au seuil de détermination ; et
le module de réglage de tension de charge est adapté pour régler une tension de charge d'une tension de charge flottante à une tension de charge d'égalisation,
dans lequel le module de détection de courant est en outre adapté pour détecter un courant du circuit de charge à la tension de charge d'égalisation ; et
le module de commande logique est en outre adapté pour déterminer que la batterie est en position de fonctionnement quand la valeur du courant du circuit de charge est supérieure ou égale au seuil de détermination ; et déterminer que la batterie n'est pas en position de fonctionnement quand la valeur du courant du circuit de charge est inférieure au seuil de détermination.

3. Appareil selon la revendication 2, dans lequel le module de détection de courant comprend une résistance ou un élément à effet Hall.

4. Système de charge comprenant un chargeur, une batterie et l'appareil de détection de position de fonctionnement d'une batterie selon l'une quelconque des revendications 2 à 3, dans lequel
le chargeur est adapté pour charger la batterie à travers le circuit de charge ; et
le module de détection de courant de l'appareil de détection de position de fonctionnement d'une batterie est connecté en série dans le circuit de charge.
